# EUROPEAN PATENT SPECIFICATION

(11) **EP 3 086 627 B1**
(45) Date of publication and mention of the grant of the patent: **21.10.2020**
(21) Application number: 15165080.1
(22) Date of filing: 24.04.2015
(51) Int. Cl.: H05K 1/05, H05K 1/14, H05K 1/03

(54) **ELEVATOR COMPRISING A POWER UNIT**
AUFZUG MIT EINER ANTRIEBSEINHEIT
ASCENSEUR COMPRENANT UNE UNITÉ D'ALIMENTATION

(43) Date of publication of application: 26.10.2016
(73) Proprietor: Kone Corporation, 00330 Helsinki (FI)
(72) Inventor: Nakari, Arto, 05810 Hyvinkää (FI)
(74) Representative: Glück Kritzenberger Patentanwälte PartGmbB

(56) References cited:
- EP-A1- 0 598 914
- EP-A1- 2 635 097
- EP-A2- 2 328 391
- WO-A1-2015/022956
- DE-A1-102013 211 640
- US-A1- 2009 133 912
- US-A1- 2010 288 586
- US-A1- 2011 222 282
- US-A1- 2016 227 644
- US-B1- 6 359 784

## Description

### Background of the invention

The present invention relates to a power unit of a passenger transporting device which comprises a control circuit and a power circuit whereby the control circuit controls power semiconductors of the power circuit.

### Description of the related art

It is known that the control circuit is located on different printed circuit board than the power unit with the power semiconductors. Currently, the power semiconductors are connected with heat sinks as e.g. air coolers or metal coolers to meet the heat dissipation of the power semiconductors. It has to be born in mind that the power semiconductors sometime switch high loads, in an elevator e.g. several kW of elevator motor power.

A power unit including insulating metal substrate circuit boards known from EP 2 328 391 A2. The US 2010/0288586 A1 discloses a motor drive comprising PCBs mounted on a motor casing.

### Summary of the invention

It is object of the present invention to provide for a compact and economic solution for the power unit of a passenger transporting device.

The object is solved with a power unit according to claim 1. Preferred embodiments of the invention are subject-matter of the dependent claims. Some inventive embodiments are also discussed in the descriptive section of the present application and in the drawings. The inventive content may also consist of several separate inventions, especially if the invention is considered in the light of expressions or implicit subtasks or from the point of view of advantages achieved. In this case, some of the attributes contained in the claims below may be superfluous from the point of view of separate inventive concepts.

According to the present invention, the power semiconductors are surface mounted devices which are located on a metal substrate printed circuit board (hereinafter: MSCPB) which has a metal substrate layer covered by a dielectric layer with good heat transferring characteristics on which dielectric layer the printed circuit layer of the power circuit together with the surface mounted power semiconductors is arranged. The advantage of a MSPCB of the above-mentioned type is that it provides very compact dimensions together with excellent heat dissipating properties whereby even separate heat sinks can be omitted. Of course, the MSPCB can be mounted to a metal surface of an elevator or escalator component so that the component of the passenger transporting device itself functions as the heat sink for the metal substrate layer of the MSPCB. Usually, an MSPCB comprises a metal substrate layer of a thickness of e.g. 3 to 20 mm on which the dielectric layer with a thickness of preferably 200 *µ*/m to 3 mm is located. On this dielectric layer, the circuit layer and the electronic components of the power circuit are mounted or printed. The printed circuit layer corresponds to a standard copper layer depending on the power requirements, e.g. with a thickness between 200µm and 5 mm.

For the dielectric layer of the MSPCB, preferably a polymer layer with a thermally conductive filler is used which filler may for example be a metal filler or a boron nitride filler or a similar filler with good thermal conductive properties for dielectric materials in PCBs. The polymer matrix may comprise epoxy or polyethylene or any other standard polymer material for dielectric layers.

The metal substrate layer may for example consist of aluminum or copper.

The control circuit on the other hand comprises a separate printed circuit board (PCB) having a printed circuit layer with control circuit components as e.g. control semiconductors located on a polymer- or glass substrate as it is usually used for low and mid power applications. The advantage of this solution according to the above-specified invention is the fact that the power unit has very good heat dissipating properties and is very compact in its dimensions whereby it integrates the control and power functions of a power unit. According to the invention, the power unit is used in an elevator as the elevator motor drive. In an implementation outside the scope of the claims the power unit may also be used in an elevator for the cabin lighting or for the door controller of the car door. Furthermore, in an implementation outside the scope of the claims, in an escalator or moving ramp which form other types of passenger transporting devices, the power unit may be used for the escalator motor drive and/or for the motor brakes.

In a very compact solution of the invention, the PCB carrying the control circuit is arranged parallel to the MSPCB carrying the power circuit. This mutual parallel arrangement of the two different PCBs aims for a very flat construction of the complete power unit which therefore can be arranged in small gaps for example between a shaft wall and the elevator car in the elevator shaft adjacent to the elevator motor.

Preferably, the PCB with the control circuit is stacked on the MSPCB with the power circuit. Via this arrangement, a flat power unit is realized which is further reduced in size with respect to its width and length in the plane of the PCBs.

Preferably, in this solution, the control circuit and the power circuit are connected by pin connectors extending perpendicular to the plane of the PCBs. The pin connectors thereby lead to a better stabilization of the stacked arrangement of PCB and MSPCB. Furthermore, these pin connectors can easily be contacted with the printed circuit layers of the control circuit and power circuit. In some refinements, the pin connector is a surface-mount component and can therefore be mounted to the MSPCB in the same soldering process as the power semiconductors.

Preferably, the control circuit and the power circuit are located together with their PCB and MSPCB in a housing whereby the metal substrate of the MSPCB preferably forms the bottom or a surface of the housing. With such a solution, the heat dissipation via the metal substrate is not affected by the housing and on the other hand, all the components of the control circuit as well as of the power circuit are secured against damage. The housing may be made of plastics or of metal. The complete space within the housing may be filled with a dielectric substance, for example a polymer substance. The thermal conductive properties of said polymer might be improved via a filler with good thermal conducting properties. In this case, the heat from the power semiconductors is not only dissipated via the metal substrate of the MSPCB, but also via the dielectric material filling the space within the housing. If this polymer filled housing is combined with a metal housing, the heat dissipation is still improved. This way the electronic components are also well protected against harsh environmental conditions, such as dust, humidity etc..

Preferably, the width and length of the housing in the direction of the MSPCB plane are both larger than the height of the housing. This leads to a flat arrangement which can be easily placed to any metal surface of a component of a passenger transporting device, e.g. a wall or ceiling of the elevator car or to a metal wall of a control cabinet or to a door supporter beam in case of a door controller.

In a preferred embodiment of the invention, a power interface connector is located on the PCB of the control circuit which power interface connector is connected to the control circuit. In this case a power connector is located on the MSPCB which is connected to the power semiconductors of the power circuit as well as to the power interface connector located on the PCB.

Via this measure, power data can easily be transferred from the MSPCB of the power circuit to the control circuit.

According to the invention, the power unit is a brake controller for a drive motor or the brakes of an elevator whereby in this case, the power unit is located with the metal substrate layer of the MSPCB in contact with a metal plane of a component of the elevator. This allows excellent heat dissipation without needing separate heat sinks or active coolers.

As an alternative implementation outside the scope of the invention, the power unit may be a motor drive of a drive motor of an escalator or a moving walk. In some refinements the flat construction of the power unit makes it possible to install the power unit inside the moving track of an escalator / moving walk or to direct extension in the end of the moving track.

The invention relates to an elevator having at least one power unit according to the above-mentioned specifications.

The power unit in the elevator is an elevator drive, particularly a frequency converter, whereby the metal substrate layer of the MSPCB of the power unit is connected to a fixed metal structure in the elevator shaft and is located preferably adjacent to the elevator motor which is also located in the elevator shaft. This solution has the advantage that on one hand, the power unit is located near the elevator motor so that the power lines between the elevator motor drive and the elevator motor can be kept short and on the other hand, the heat dissipation of the power unit in the elevator shaft is very good, particularly if the metal substrate layer of the power unit is connected to a metal surface of an elevator or building component in the elevator shaft. For example, the metal substrate layer of an elevator motor drive may be connected to a bedplate or other support structure of an elevator hoisting machine. Thus, this solution combines short power lines with a good heat dissipation.

In another implementation outside the scope of the invention, the power unit is an elevator car lighting unit whereby the metal substrate layer of the power unit is connected to a metal surface of the elevator car, particularly the car ceiling. Also in this case, the power lines between the car lighting device and the power unit can be kept short and on the other hand, the power unit is cooled effectively via the connection of the metal substrate layer of the MSPCB to the metal surface of the elevator car.

Further, in an implementation outside the scope of the invention, the power unit is a door operator whereby the metal substrate layer of the power unit is connected to an upper supporting beam of an elevator door. Also in this case, the power line between the power unit and the door motor can be kept short and on the other hand, the power unit is cooled effectively via the metal substrate layer of the MSPCB being in contact with the upper supporting beam (also called door supporter).

The power semiconductors in the power unit may be per se known components as for example MOSFETs or IGBTs.

It is apparent that components of the independent claims may be provided as a single component or as multiple components. Thus, the MSPCB or the PCB can consist of only one part or of several parts which may be arranged such that the overall dimensions are preferably reduced as much as possible or which take into consideration the optimal heat dissipating properties of the power unit in total.

### Brief description of the drawings

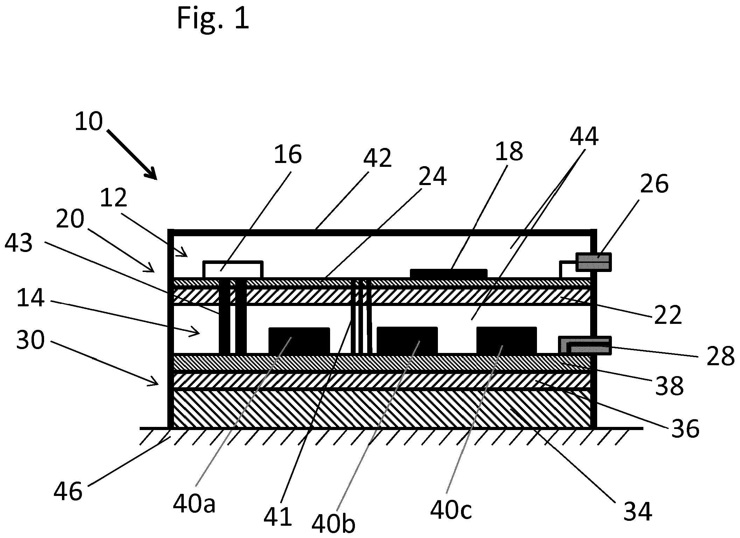

The invention will now be described with respect to an example in connection with the schematic drawing. In this drawing
- Fig. 1: shows a partly sectioned side view of a power unit according to the present invention.

### Description of the preferred embodiments

The power unit 10 for a passenger transporting device comprises a control circuit 12 and a power circuit 14. The control circuit 12 comprises different electronic components 16, 18 and a PCB 20 to which the electronic components 16, 18 are mounted. The PCB is a conventional printed circuit board consisting of a polymer substrate 22 as for example laminated epoxy on which the circuit layer 24 of the control circuit 12 is printed. The printed circuit layer 24 is preferably a copper layer which is per se known in the art. The electronic components 16, 18 located together with the printed circuit layer 24 on the polymer substrate 22 of the PCB 20 are a power interface connector 16 as well as an integrated circuit 18 for the control function of the control circuit 12. The control circuit may of course comprise further electronic components as semiconductor switches, integrated circuits, diodes, capacitors, etc.

The PCB 20 is stacked above an MSPCB 30 of the power circuit 14 which comprises a metal layer 32, e.g. copper or aluminum, a dielectric layer 36 laminated on the metal substrate 32 as well as a printed circuit layer 38 on the dielectric layer 36. The4 dielectric layer 36 preferably comprises a polymer matrix and a filler with good thermal conductive properties as e.g. a metal filler or boron nitride filler. The printed circuit layer 38 of the power circuit 14 is preferably made of copper. Also power transistors 40a, 40b, 40c are located in said printed circuit layer 38, which power transistors 40a, 40b are embodied as surface mounted power semiconductors, e.g. MOSFETs or IGBTs. Usually, the number of power semiconductors on the MSPCB is six, i.e. one for each half wave of three phases of AC. The control circuit 12 with the PCB 20 as well as the power circuit 14 with the MSPCB 30 are parallel to each other and stacked above each other and are mounted within a housing 42 which is made of plastics or of metal. The control circuit 12 and the power circuit 14 are electrically connected via pin header connectors 41 for the signal lines as well as with high current pin connectors 43 which connect the printed circuit layer 38 of the power circuit 14 with the power interface connector 16 of the control circuit 12.

Above the MSPCB 30 and within the housing 42, a hollow space 44 is formed which may be filled with a dielectric material, for example a polymer matrix, preferably comprising a thermally conductive filler as e.g. boron nitride filler or metal filler to increase also the heat dissipation form heat generating components of the control circuit 12 and power circuit 14 to the walls of the housing 42.

The power unit 10 is embodied as a very compact flat structure provided safely in a closed housing 42 to which only a first external connector 26 of the control circuit 12 and an external power connector 28 of the power circuit 14 protrude through the housing walls as to provide an interface to contact the control circuit 12 as well as the power circuit 14 independently. The metal substrate 34 of the MSPCB 30 is connected to a metal surface 46 of a component of a passenger transporting device, e.g. of an escalator, moving walk or elevator, so that the heat dissipation from the power semiconductors 40a,b,c via the dielectric layer 36 and the metal substrate layer 34 is improved by using the metal surface 46 of the passenger transporting device component as a kind of heat sink.

The invention is not limited to the above described embodiments but may be varied within the scope of the appended patent claims.

### List of reference numbers

- 10: Power unit
- 12: control circuit
- 14: power circuit
- 16: power interface connector
- 18: integrated circuit IC
- 20: printed circuit board PCB
- 22: polymer substrate
- 24: printed circuit layer of the control circuit
- 26: first external connector of control circuit
- 28: second external connector for power circuit (e.g. motor connector)
- 30: metal substrate printed circuit board MSPCB
- 34: metal substrate
- 36: dielectric layer
- 38: printed circuit layer of the power circuit
- 40a: first power semiconductor
- 40b: second power semiconductor
- 40c: third power semiconductor
- 41: pin header connectors for signal lines
- 42: housing
- 43: high current pin connectors
- 44: space within the housing to be filled with a polymer, e.g. mixed with filler (soft molding)
- 46: metal surface of component of the passenger transporting device

## Claims

1. Elevator comprising at least one power unit (10) of the elevator, which is a brake controller (10) for the drive motor brakes of the elevator or which is an elevator motor drive, the power unit (10) comprising a control circuit (12) and a power circuit (14), whereby the power circuit (14) comprises several discrete surface mounted power semiconductors (40a, 40b, 40c) which are located on a metal substrate printed circuit board (MSPCB) (30), which MSPCB (30) has a metal substrate layer (34) covered by a dielectric layer (36) on which a circuit layer (38) with the power semiconductors (40a, 40b, 40c) is arranged,
and the control circuit (12) comprises a separate printed circuit board (PCB) (20) consisting of a circuit layer (24) with control circuit components (16, 18) located on a polymer- or glass substrate (22), **characterized in that** the metal substrate layer of the MSPCB of the brake controller is in contact with a metal plane of an elevator component or **in that** the metal substrate layer of the MSPCB of the elevator motor drive is connected to a fixed metal structure of an elevator component in the elevator shaft.

2. Elevator according to claim 1, wherein the dielectric layer (36) of the MSPCB (30) comprises a filler in a polymer matrix, whereby the thermal conductivity of the filler is higher than that of the polymer matrix.

3. Elevator according to claim 2, wherein the filler comprises boron nitride or metal, Cu, Ag or a combination thereof.

4. Elevator according to claim 2 or 3, wherein the polymer matrix comprises epoxy or PE.

5. Elevator according to one of the preceding claims, wherein the PCB (20) is arranged parallel to the MSPCB (30).

6. Elevator according to claim 5, wherein the PCB (20) is stacked on the MSPCB (30).

7. Elevator according to claim 6, wherein the control circuit (12) and the power circuit (14) are connected by pin connectors (41, 43) extending perpendicular to the plane of the MSPCB (30).

8. Elevator according to one of the preceding claims, wherein the control circuit (12) and the power circuit (14) are located in a housing (42) with the metal substrate layer (34) of the MSPCB (30) forming the bottom or a surface of the housing (42).

9. Elevator according to claim 8, wherein the width and length of the housing (42) in the direction of the MSPCB plane are both larger than the height of the housing (42).

10. Elevator according to claim 8 or 9, wherein the space between the housing (42) and the MSPCB (30) is filled with a polymer.

11. Elevator according to one of the preceding claims, wherein on the PCB (20) a power interface connector (16) is located which is connected to the control circuit (12) and at least one high current pin connector (43) is extending between the MSPCB (30) and the PCB (20) which is connected to the power semiconductors (40a, 40b, 40c) of the power circuit (14) and to the power interface connector (16).

12. Elevator according to one of the preceding claims, wherein the power unit (10) is an elevator motor drive, particularly a frequency converter, whereby the metal substrate layer (34) of the power unit is connected to a fixed metal structure (46) located adjacent to the elevator motor in the elevator shaft.

## Patentansprüche

1. Aufzug mit mindestens einer Leistungseinheit (10) des Aufzugs, die eine Bremssteuerung (10) für die Antriebsmotorbremsen des Aufzugs ist oder die ein Aufzug-Motorantrieb ist, wobei die Leistungseinheit (10) eine Steuerschaltung (12) und eine Leistungsschaltung (14) aufweist, wobei die Leistungsschaltung (14) mehrere diskrete oberflächenmontierte Leistungshalbleiter (40a, 40b, 40c) umfasst, die sich auf einer Metallsubstrat-Leiterplatte (MSPCB) (30) befinden, wobei die MSPCB (30) eine Metallsubstratschicht (34) aufweist, die von einer dielektrischen Schicht (36) bedeckt ist, auf der eine Schaltungsschicht (38) mit den Leistungshalbleitern (40a, 40b, 40c) angeordnet ist,
und die Steuerschaltung (12) eine separate Leiterplatte (PCB) (20) umfasst, die aus einer Schaltungsschicht (24) mit Steuerschaltungskomponenten (16, 18) besteht, die auf einem Polymer- oder Glassubstrat (22) angeordnet sind, **dadurch gekennzeichnet, dass** die Metallsubstratschicht des MSPCB der Bremssteuerung mit einer Metallebene einer Aufzugskomponente in Kontakt steht oder dass die Metallsubstratschicht des MSPCB des Aufzugsmotorantriebs mit einer festen Metallstruktur einer Aufzugskomponente im Aufzugsschacht verbunden ist.

2. Aufzug nach Anspruch 1, wobei die dielektrische Schicht (36) des MSPCB (30) einen Füllstoff in einer Polymermatrix umfasst, wobei die Wärmeleitfähigkeit des Füllstoffs höher als die der Polymermatrix ist.

3. Aufzug nach Anspruch 2, wobei der Füllstoff Bornitrid oder Metall, Cu, Ag oder eine Kombination davon umfasst.

4. Aufzug nach Anspruch 2 oder 3, wobei die Polymermatrix Epoxid oder PE umfasst.

5. Aufzug nach einem der vorstehenden Ansprüche, wobei die PCB (20) parallel zur MSPCB (30) angeordnet ist.

6. Aufzug nach Anspruch 5, bei dem die PCB (20) auf der MSPCB (30) angeordnet ist.

7. Aufzug nach Anspruch 6, wobei die Steuerschaltung (12) und die Leistungsschaltung (14) durch Stiftverbinder (41, 43) verbunden sind, die sich senkrecht zur Ebene der MSPCB (30) erstrecken.

8. Aufzug nach einem der vorhergehenden Ansprüche, wobei die Steuerschaltung (12) und die Leistungsschaltung (14) in einem Gehäuse (42) angeordnet sind, wobei die Metallsubstratschicht (34) der MSPCB (30) den Boden oder eine Oberfläche des Gehäuses (42) bildet.

9. Aufzug nach Anspruch 8, wobei die Breite und die Länge des Gehäuses (42) in der Richtung der MSPCB-Ebene beide größer als die Höhe des Gehäuses (42) sind.

10. Aufzug nach Anspruch 8 oder 9, wobei der Raum zwischen dem Gehäuse (42) und dem MSPCB (30) mit einem Polymer gefüllt ist.

11. Aufzug nach einem der vorhergehenden Ansprüche, wobei sich auf der Leiterplatte (20) ein Leistungsschnittstellenverbinder (16) befindet, der mit der Steuerschaltung (12) verbunden ist, und sich mindestens ein Hochstromstiftverbinder (43) zwischen dem MSPCB (30) und der Leiterplatte (20) erstreckt, der mit den Leistungshalbleitern (40a, 40b, 40c) der Leistungsschaltung (14) und dem Leistungsschnittstellenverbinder (16) verbunden ist.

12. Aufzug nach einem der vorstehenden Ansprüche, wobei die Leistungseinheit (10) ein Aufzugsmotorantrieb, insbesondere ein Frequenzumrichter, ist, wobei die Metallsubstratschicht (34) der Leistungseinheit mit einer festen Metallstruktur (46) verbunden ist, die neben dem Aufzugsmotor im Aufzugsschacht angeordnet ist.

## Revendications

1. Ascenseur comprenant au moins une unité d'alimentation (10) de l'ascenseur, laquelle est un régulateur de freinage (10) pour les freins de moteur d'entraînement de l'ascenseur ou laquelle est un entraînement de moteur d'ascenseur, l'unité d'alimentation (10) comprenant un circuit de commande (12) et un circuit d'alimentation (14), dans lequel le circuit d'alimentation (14) comprend plusieurs semi-conducteurs d'alimentation discrets montés en surface (40a, 40b, 40c) qui sont situés sur une carte de circuit imprimé de substrat métallique (MSPCB) (30), laquelle MSPCB (30) présente une couche de substrat métallique (34) couverte par une couche diélectrique (36) sur laquelle une couche de circuit (38) avec les semi-conducteurs d'alimentation (40a, 40b, 40c) est agencée,
et le circuit de commande (12) comprend une carte de circuit imprimé (PCB) (20) séparée consistant en une couche de circuit (24) avec des composants de circuit de commande (16, 18) situés sur un substrat polymère ou verre (22), **caractérisé en ce que** la couche de substrat métallique de la MSPCB du régulateur de freinage est en contact avec un plan métallique d'un composant d'ascenseur ou **en ce que** la couche de substrat métallique de la MSPCB de l'entraînement de moteur d'ascenseur est reliée à une structure métallique fixe d'un composant d'ascenseur dans la cage d'ascenseur.

2. Ascenseur selon la revendication 1, dans lequel la couche diélectrique (36) de la MSPCB (30) comprend un matériau de remplissage dans une matrice polymère, dans lequel la conductivité thermique du matériau de remplissage est supérieure à celle de la matrice polymère.

3. Ascenseur selon la revendication 2, dans lequel le matériau de remplissage comprend du nitrure de bore ou du métal, du Cu, ou de l'Ag ou une combinaison de ceux-ci.

4. Ascenseur selon la revendication 2 ou 3, dans lequel la matrice polymère comprend de l'époxy ou du PE.

5. Ascenseur selon une des revendications précédentes, dans lequel la PCB (20) est agencée parallèlement à la MSPCB (30).

6. Ascenseur selon la revendication 5, dans lequel la PCB (20) est empilée sur la MSPCB (30).

7. Ascenseur selon la revendication 6, dans lequel le circuit de commande (12) et le circuit d'alimentation (14) sont reliés par des connecteurs à broches (41, 43) s'étendant perpendiculairement au plan de la MSPCB (30).

8. Ascenseur selon une des revendications précédentes, dans lequel le circuit de commande (12) et le circuit d'alimentation (14) sont situés dans un boîtier (42) avec la couche de substrat métallique (34) de la MSPCB (30) formant le fond ou une surface du boîtier (42).

9. Ascenseur selon la revendication 8, dans lequel la largeur et la longueur du boîtier (42) dans la direction du plan de la MSPCB sont toutes deux supérieures à la hauteur du boîtier (42).

10. Ascenseur selon la revendication 8 ou 9, dans lequel l'espace entre le boîtier (42) et la MSPCB (30) est rempli d'un polymère.

11. Ascenseur selon une des revendications précédentes, dans lequel sur la PCB (20) un connecteur d'interface d'alimentation (16) est situé, lequel est relié au circuit de commande (12) et au moins un connecteur à broches à courant fort (43) s'étendant entre la MSPCB (30) et la PCB (20) lequel est relié aux semi-conducteurs d'alimentation (40a, 40b, 40c) du circuit d'alimentation (14) et au connecteur d'interface d'alimentation (16).

12. Ascenseur selon une des revendications précédentes, dans lequel l'unité d'alimentation (10) est un entraînement de moteur d'ascenseur, en particulier un convertisseur de fréquence, dans lequel la couche de substrat métallique (34) de l'unité d'alimentation est reliée à une structure métallique fixe (46) située de manière adjacente au moteur d'ascenseur dans la cage d'ascenseur.
